# FASCICULE DE BREVET EUROPEEN

(11) **EP 2 979 307 B1**
(45) Date de publication et mention de la délivrance du brevet: **24.07.2019**
(21) Numéro de dépôt: 14712005.9
(22) Date de dépôt: 25.03.2014
(51) Int. Cl.: H01L 33/06, H01L 33/14, H01L 33/12

(54) **DIODE ELECTROLUMINESCENTE A MULTIPLES PUITS QUANTIQUES ET JONCTION P-N ASYMETRIQUE**
LEUCHTDIODE MIT MEHREREN QUANTENTÖPFEN UND ASYMMETRISCHER P-N-VERBINDUNG
LIGHT-EMITTING DIODE WITH MULTIPLE QUANTUM WELLS AND ASYMMETRIC P-N JUNCTION

(30) Priorité: 28.03.2013 FR 1352839
(43) Date de publication de la demande: 03.02.2016
(73) Titulaire: Commissariat à l'Énergie Atomique et aux Énergies Alternatives, 75015 Paris (FR)
(72) Inventeur: ROBIN, Ivan-Christophe, F-38000 Grenoble (FR); BONO, Hubert, F-38000 Grenoble (FR)
(74) Mandataire: Brevalex
(86) Numéro de dépôt international: PCT/EP2014/055964
(87) Numéro de publication internationale: WO 2014/154690

(56) Documents cités:
- EP-A2- 1 914 813
- EP-A2- 1 914 813
- EP-A2- 2 610 927
- WO-A1-2013/114152
- US-A1- 2010 270 531
- US-B2- 8 053 756

## Description

### DOMAINE TECHNIQUE ET ART ANTÉRIEUR

L'invention concerne le domaine des diodes électroluminescentes (appelées DEL ou LED) à multiple puits quantiques.

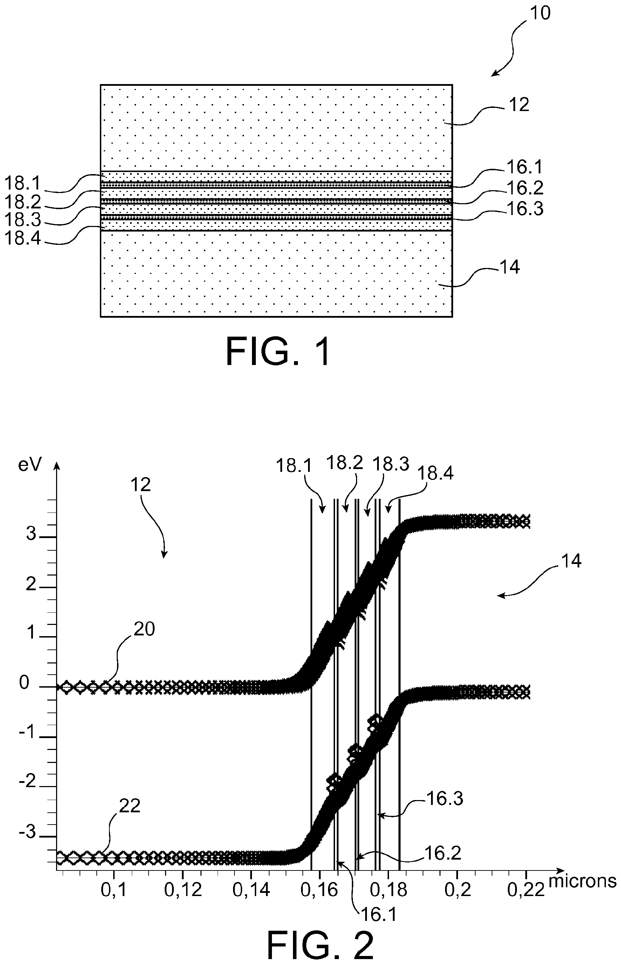

La figure 1 représente schématiquement une diode 10 à multiples puits quantiques de l'art antérieur.

Cette diode 10 comporte une jonction p-n formée par une première couche 12 de GaN dopé n (GaN-n) avec une concentration égale à 10¹⁹ donneurs/cm³ et une deuxième couche 14 de GaN dopé p (GaN-p) avec une concentration égale à 2.10¹⁹ accepteurs/cm³, ces deux couches ayant par exemple chacune une épaisseur égale à plusieurs microns.

Plusieurs couches émissives 16 sont disposées entre les couches 12 et 14. La diode 10 décrite ici comporte trois couches émissives 16, référencées 16.1, 16.2 et 16.3 sur la figure 1, formant chacune un puits quantique. Les couches émissives 16 sont à base d'In_{0,16}Ga_{0,84}N (comprenant 16 % d'indium pour 84 % de gallium) non intentionnellement dopé (avec une concentration de donneurs résiduels n_{nid} = 10¹⁷ cm⁻³) et d'épaisseur égale à 1 nm. Des couches barrières 18 (au nombre de quatre dans la diode 10, et référencées 18.1, 18.2, 18.3 et 18.4) à base de GaN non intentionnellement dopé (avec une concentration de donneurs résiduels n_{nid} = 10¹⁷ cm⁻³) et d'épaisseur égale à 5 nm sont également disposées entre les couches 12 et 14. Deux des quatre couches barrières 18 sont interposées chacune entre deux couches émissives 16 consécutives, et les deux autres couches barrières 18 sont chacune interposée entre une des couches émissives 16 et l'une des couches 12 et 14.

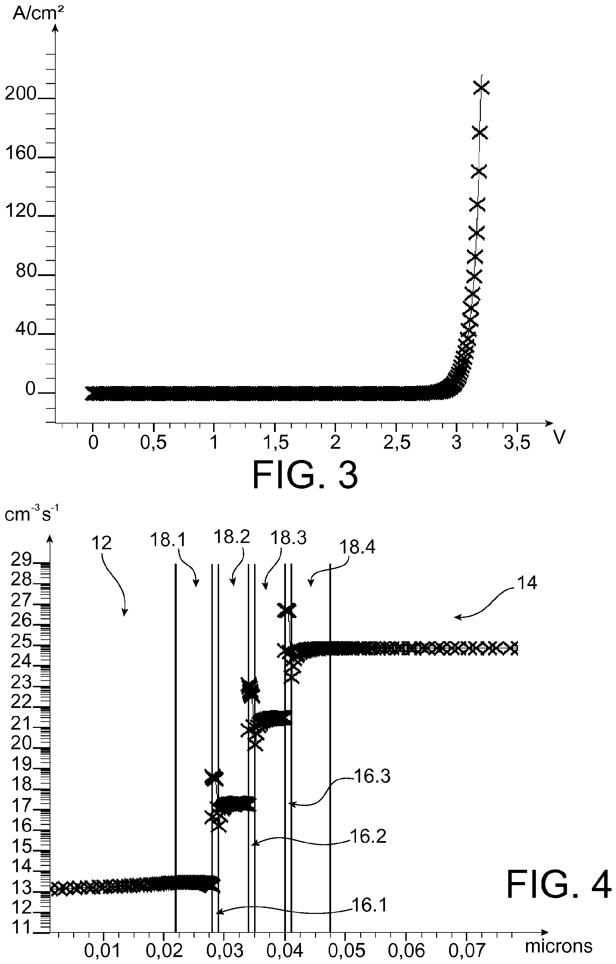

Pour polariser la diode 10, des contacts électriques sont pris du côté de la première couche 12 (formant alors une cathode de la diode 10) et de la deuxième couche 14 (formant une anode de la diode 10). La structure de bandes à 0 V de la diode 10 ainsi polarisée, au sein des différentes couches de la diode 10 est représentée sur la figure 2. Sur cette figure, la bande de conduction, en eV, comporte la référence 20 et la bande de valence, également en eV, comporte la référence 22. La caractéristique I(V) de la diode 10, c'est-à-dire la valeur de la densité de courant à l'anode de la diode 10 en fonction de la tension à l'anode de la diode 10, est représentée sur la figure 3. On voit sur la figure 3 qu'une tension de polarisation de 3,2 V appliquée entre l'anode et la cathode de la diode 10 permet d'obtenir, à l'anode de la diode 10, une densité de courant de 250 A/cm² qui correspond typiquement à la densité de courant souhaitée dans une diode électroluminescente à forte brillance.

La figure 4 représente le taux de recombinaisons radiatives, en échelle logarithmique et par cm³.s, obtenues dans les différentes couches de la diode 10, avec cette tension de polarisation de 3,2 V appliquée entre l'anode et la cathode de la diode 10. On voit sur cette figure qu'un taux de recombinaisons d'environ 10²⁷ cm⁻³s⁻¹ est obtenu dans le puits quantique formé par la troisième couche émissive 16.3. Par contre, ce taux de recombinaisons radiatives chute à environ 10²³ cm⁻³s⁻¹ dans la deuxième couche émissive 16.2 et à environ 1.10¹⁹ cm⁻³s⁻¹ dans la première couche émissive 16.1. L'émission lumineuse obtenue avec la diode 10 est donc très mal répartie entre les trois puits quantiques de la diode 10.

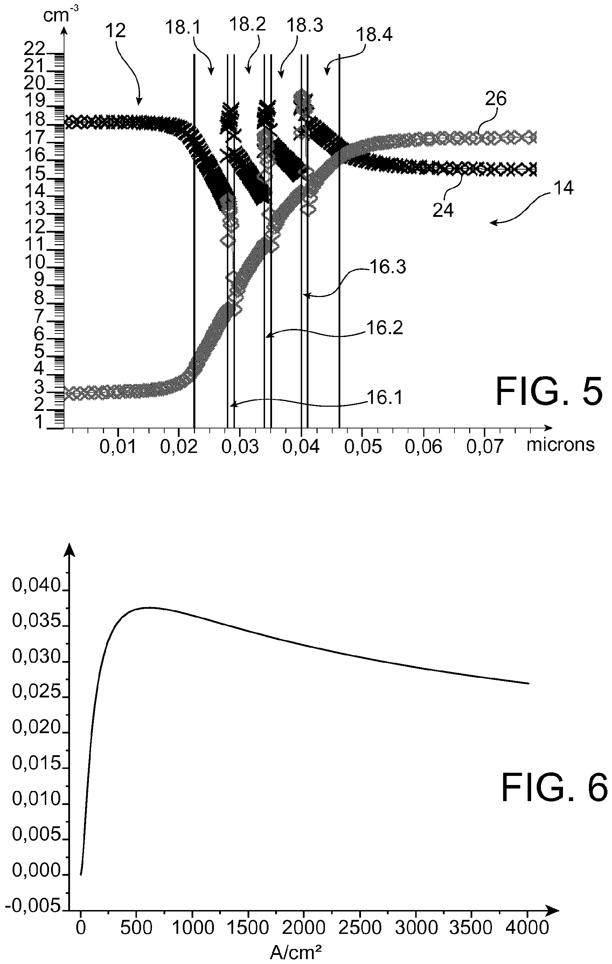

Cette mauvaise répartition de l'émission lumineuse dans la diode 10 est due à une répartition non homogène des charges, et notamment des trous, entre les différents puits quantiques car le taux de recombinaisons radiatives dans les puits quantiques est directement proportionnel au produit de la concentration des trous et des électrons dans les puits quantiques. La figure 5 représente les concentrations en électrons (représentées par des croix référencées 24) et en trous (représentées par des losanges référencés 26), par cm³, obtenues dans les différentes couches de la diode 10 polarisée comme précédemment avec une tension de 3,2 V. On voit sur cette figure 5 que les électrons ont tendance à passer dans la deuxième couche 14 de GaN-p, ce qui diminue le taux de recombinaisons radiatives dans les puits quantiques de la diode 10. Pour palier à ce problème, il est connu d'interposer une couche de blocage d'électrons à base d'AIGaN entre la quatrième couche barrière 18.4 et la deuxième couche 14 de GaN-p. Par contre, on voit également sur cette figure que les trous ne sont pas répartis de manière homogène dans les puits quantiques : il y a environ 10¹⁹ trous/cm³ dans le puits quantique formé par la troisième couche émissive 16.3 se trouvant du côté de la deuxième couche 14 de GaN-p alors qu'il y a environ 10¹⁷ trous/cm³ dans le puits quantique formé par la deuxième couche émissive 16.2 et environ 10¹⁴ trous/cm³ dans le puits quantique formé par la première couche émissive 16.1 se trouvant du côté de la première couche 12 de GaN-n. La concentration en électrons est par contre homogène entre les différents puits quantiques et égale à environ 10¹⁹ cm⁻³. Le fait que l'émission lumineuse de la diode 10 ne provient que du puits quantique formé par la troisième couche émissive 16.3 se trouvant du côté de la deuxième couche 14 de GaN-p provient du fait que les trous ne sont pas répartis de manière homogène entre les différents puits quantiques de la diode 10.

Le rendement quantique interne de la diode 10, qui correspond au rapport entre le nombre d'électrons injectés et le nombre de photons émis par les puits quantiques de la diode 10, en fonction de la densité de courant (en A/cm²) dans la diode 10 est représenté sur la figure 6. On voit sur cette figure que le rendement quantique interne maximum de la diode 10 est d'environ 4 % et est obtenu pour une densité de courant d'environ 600 A/cm². Ce rendement quantique interne est limité par :
- les recombinaisons non radiatives de type Auger et Shockley-Read-Hall se produisant dans la diode 10,
- l'échappement des électrons depuis les puits quantiques vers la deuxième couche 14 de GaN-p,
- mais également du fait que l'émission lumineuse n'est pas réalisée de façon homogène dans les différents puits quantiques de la diode.

Les documents EP 1914813 A2 et US 8 053 756 B2 décrivent des diodes électroluminescentes comportant une couche tampon en InGaN disposée entre la première couche de semiconducteur dopé n et la zone active comportant des couches émissives et des couches barrières en InGaN.

### EXPOSÉ DE L'INVENTION

Un but de la présente invention est de proposer une diode électroluminescente à multiples puits quantiques présentant un meilleur rendement quantique interne que les diodes électroluminescentes de l'art antérieur.

Pour cela, il est proposé une diode électroluminescente comportant :
- une première couche de semi-conducteur dopé n apte à former une cathode de la diode, et une deuxième couche de semi-conducteur dopé p apte à former une anode de la diode, telles que la première couche et la deuxième couche forment une jonction p-n de la diode ;
- une zone active disposée entre la première couche et la deuxième couche, comprenant au moins deux couches émissives comportant du semi-conducteur et aptes à former des puits quantiques, et une pluralité de couches barrières de semi-conducteur telles que chaque couche émissive soit disposée entre deux couches barrières qui sont en contact avec ladite couche émissive au niveau de deux faces opposées de ladite couche émissive ;
- une couche tampon de semi-conducteur dopé n disposée entre la première couche et la zone active, ledit semi-conducteur dopé n de la couche tampon comportant une énergie de bande interdite inférieure ou égale à environ 97 % de l'énergie de bande interdite du semi-conducteur dopé p de la deuxième couche.

L'invention propose en outre une diode électroluminescente comportant :
- une première couche de semi-conducteur dopé n apte à former une cathode de la diode, et une deuxième couche de semi-conducteur dopé p apte à former une anode de la diode, la première et la deuxième couche formant une jonction p-n de la diode ;
- une zone active disposée entre la première couche et la deuxième couche, comprenant au moins deux couches émissives comportant du semi-conducteur et aptes à former des puits quantiques, et une pluralité de couches barrières de semi-conducteur telles que chaque couche émissive soit disposée entre deux couches barrières qui sont en contact avec ladite couche émissive au niveau de deux faces opposées de ladite couche émissive ;
- une couche tampon de semi-conducteur dopé n disposée entre la première couche et la zone active, ledit semi-conducteur dopé n de la couche tampon comportant une énergie de bande interdite inférieure ou égale à environ 97 % de l'énergie de bande interdite du semi-conducteur dopé p de la deuxième couche ;
dans laquelle le semi-conducteur des couches barrières est de l'In_{X}Ga_{1-X}N, le semi-conducteur de la couche tampon est de l'In_{Z}Ga_{1-Z}N, et le semi-conducteur des couches émissives est de l'In_{Y}Ga_{1-Y}N, avec x, y et z nombres réels tels que 0,025 ≤ x, et 0,025 ≤ z, et 0,1 ≤ y, et x < y, et z < y, ou
dans laquelle, lorsque la diode comporte m couches barrières, le semi-conducteur de chacune des couches barrières est de l'In_{Xi}Ga_{1-Xi}N, avec i nombre entier compris entre 1 et m, le semi-conducteur de la couche tampon est de l'In_{Z}Ga_{1-Z}N, et le semi-conducteur des couches émissives est de l'In_{Y}Ga_{1-Y}N, avec xᵢ, y et z nombres réels tels que 0,025 ≤ z, et 0,1 ≤ y, et xᵢ < y, et z < y, et dans laquelle la composition en indium xᵢ du semi-conducteur de chaque couche barrière est différente de celles des autres couches barrières, ces compositions en indium variant graduellement de manière décroissante depuis une première valeur x₁, correspondant à la composition en indium du semi-conducteur d'une des couches barrières disposée contre la couche tampon, telle que x₁ ≤ z, jusqu'à une autre valeur xₘ correspondant à la composition en indium du semi-conducteur d'une des couches barrières disposée contre la deuxième couche, telles que xₘ < x₁, et avec m ≥ 3.

Par rapport aux diodes électroluminescentes à multiples puits quantiques de l'art antérieur, la diode électroluminescente selon l'invention comporte une couche tampon de semi-conducteur dopé n créant, de part son énergie de bande interdite inférieure ou égale à environ 97 % de l'énergie de bande interdite de la deuxième couche, c'est-à-dire telle que le gap de la couche tampon soit inférieur d'au moins 3 % par rapport au gap de la deuxième couche de semi-conducteur dopé p de la jonction p-n (Eg₁₁₀ ≤ 0,97 Eg₁₀₄), une asymétrie dans la structure de la diode, et plus particulièrement une asymétrie dans la jonction p-n de la diode. Cette asymétrie facilite la circulation des trous dans la diode et permet d'obtenir une répartition homogène des porteurs (électrons et trous) dans les différents puits quantiques de la zone active de la diode. Cela se traduit par une émission lumineuse homogène dans les différents puits quantiques de la diode et donc par un meilleur rendement quantique interne de la diode.

De préférence, le gap de la couche tampon est supérieur d'au moins 2 % par rapport au gap des couches émissives, ou puits quantiques, améliorant ainsi le confinement dans les puits quantiques (Eg₁₁₀ ≥ 1,02 Eg₁₀₆).

Le semi-conducteur dopé n de la première couche et/ou le semi-conducteur dopé p de la deuxième couche peuvent être du GaN, et/ou les semi-conducteurs des couches émissives et/ou des couches barrières et/ou de la couche tampon peuvent être de l'InGaN.

Une concentration en indium du semi-conducteur dopé n de la couche tampon, comprenant par exemple de l'InGaN, peut être supérieure d'au moins 2,5 % par rapport à une concentration en indium du semi-conducteur dopé p de la deuxième couche, comprenant par exemple du GaN (avec dans ce cas une concentration en indium nulle dans le semi-conducteur dopé p de la deuxième couche) ou de l'InGaN.

La couche tampon et la première couche peuvent comporter un semi-conducteur de composition et/ou de dopage identiques. Ainsi, la composition en indium, c'est-à-dire le pourcentage d'indium, du semi-conducteur dopé n de la première couche peut être similaire à la composition en indium du semi-conducteur de la couche tampon, et/ou la concentration de donneurs dans le semi-conducteur dopé n de la première couche peut être similaire à la concentration de donneurs dans le semi-conducteur dopé n de la couche tampon.

Le semi-conducteur des couches barrières peut être de l'InₓGa_{1-X}N, le semi-conducteur de la couche tampon peut être de l'In_{Z}Ga_{1-Z}N, et le semi-conducteur des couches émissives peut être de l'In_{Y}Ga_{1-Y}N, avec x, y et z nombres réels tels que 0,025 ≤ x ≤ 0,13, ou 0,025 ≤ x ≤ 0,3, et 0,025 ≤ z ≤ 0,13 ou 0,025 ≤ z ≤ 0,3, et 0,1 ≤ y ≤ 0,3 ou 0,1 ≤ y ≤ 0,5, et x < y, et z < y.

Une épaisseur de la couche tampon peut être supérieure à environ 5 nm.

Lorsque la diode comporte un nombre n de couches émissives tel que 2 ≤ n ≤ 5, les semi-conducteurs des couches barrières et des couches émissives peuvent être tels que (x + 0,03) ≤ y.

En variante, lorsque la diode comporte un nombre n de couches émissives tel que 5 ≤ n ≤ 10, les semi-conducteurs des couches barrières et des couches émissives peuvent être tels que x ≥ 0,04 et (x + 0,03) ≤ y, et/ou l'épaisseur de la couche tampon peut être supérieure à environ 20 nm.

En variante, lorsque la diode comporte un nombre n de couches émissives tel que n ≥ 10, les semi-conducteurs des couches barrières et des couches émissives peuvent être tels que x ≥ 0,06 et (x + 0,03) ≤ y, et/ou l'épaisseur de la couche tampon peut être supérieure à environ 20 nm.

Les couches barrières peuvent être toutes à base d'un semi-conducteur de même composition. De plus, il est également possible que z = x ou que z ≥ x (et donc que l'énergie de gap de la couche tampon soit inférieure ou égale à celle des couches barrières), c'est-à-dire que la composition en indium du semi-conducteur de la couche tampon soit sensiblement égale ou supérieure à la composition en indium du semi-conducteur des couches barrières. Cela favorise encore plus le passage des trous, et donc l'homogénéisation de l'émission dans les puits.

En variante, lorsque la diode comporte m couches barrières, le semi-conducteur de chacune des couches barrières peut être de l'In_{Xi}Ga_{1-Xi}N, avec i nombre entier compris entre 1 et m, le semi-conducteur de la couche tampon peut être de l'In_{Z}Ga_{1-Z}N, et le semi-conducteur des couches émissives peut être de l'In_{Y}Ga_{1-Y}N, avec xᵢ, y et z nombres réels tels que 0,025 ≤ z ≤ 0,13 ou 0,025 ≤ z ≤ 0,3, et 0,1 ≤ y ≤ 0,3 ou 0,1 ≤ y ≤ 0,5, et xᵢ < y, et z < y, et dans laquelle la composition en indium xᵢ du semi-conducteur de chaque couche barrière peut être différente de celles des autres couches barrières, ces compositions en indium pouvant varier graduellement de manière décroissante depuis une première valeur x₁, correspondant à la composition en indium du semi-conducteur d'une des couches barrières disposée contre la couche tampon, telle que x₁ = z ou x₁ ≤ z, jusqu'à une autre valeur xₘ correspondant à la composition en indium du semi-conducteur d'une des couches barrières disposée contre la deuxième couche, telles que xₘ < x₁, et avec m ≥ 3.

Lorsque la diode comporte un nombre n de couches émissives tel que 2 ≤ n ≤ 5, les semi-conducteurs des couches barrières et des couches émissives peuvent être tels que x₁ > 0,04 et xₘ ≥ 0,005, et (x₁ + 0,03) ≤ y.

En variante, lorsque la diode comporte un nombre n de couches émissives tel que 5 ≤ n ≤ 10, les semi-conducteurs des couches barrières et des couches émissives peuvent être tels que x₁ > 0,08 et xₘ ≥ 0,005 et (x₁ + 0,03) ≤ y, et/ou l'épaisseur de la couche tampon peut être supérieure à environ 20 nm.

En variante, lorsque la diode comporte un nombre n de couches émissives tel que n ≥ 10, les semi-conducteurs des couches barrières et des couches émissives peuvent être tels que x₁ > 0,12 et xₘ ≥ 0,025 et (x₁ + 0,03) ≤ y, et/ou l'épaisseur de la couche tampon peut être supérieure à environ 20 nm.

La composition en indium z du semi-conducteur de la couche tampon peut varier entre une première valeur z₁ et une deuxième valeur z₂ supérieure à la première valeur z₁ selon une direction sensiblement perpendiculaire à une première face de la couche tampon contre laquelle la première couche est disposée, et la composition en indium z au niveau de la première face de la couche tampon peut être égale à la première valeur z₁, et, lorsque la composition en indium du semi-conducteur de chacune des couches barrières est différente de celle des autres couches barrières, la composition en indium x₁ peut être telle que x₁ = z₂ ou x₁ ≤ z₂.

Dans ce cas, la composition en indium z du semi-conducteur de la couche tampon peut varier de manière croissante entre z₁ et z₂, avec z₁ = 0, et z₂ = x ou z₂ ≥ x OU z₂ = x₁ ou z₂ ≥ x₁.

En variante, la composition en indium z du semi-conducteur de la couche tampon peut varier de manière croissante entre z₁ et une troisième valeur z₃ > z₂, et varier de manière décroissante entre z₃ et z₂, avec z₁ = 0 et z₂ = x ou z₂ ≥ x ou z₂ = x₁ ou z₂ ≥ x₁.

Le semi-conducteur dopé p de la deuxième couche peut être de l'In_{W}Ga_{1-W}N, avec w nombre réel tel que w < 0,12 et dans laquelle, lorsque le semi-conducteur des couches barrières est de l'In_{X}Ga_{1-X}N, que le semi-conducteur de la couche tampon est de l'In_{Z}Ga_{1-Z}N, et que le semi-conducteur des couches émissives est de l'In_{Y}Ga_{1-Y}N, les compositions en indium w, x, y et z peuvent être telles que (0,025+w) ≤ x, et (0,025+w) ≤ z, et (0,1+w) ≤ y, ou telles que (0,025+w) ≤ x ≤ (0,13+w), et (0,025+w) ≤ z ≤ (0,13+w), et (0,1+w) ≤ y ≤ (0,3+w), ou telles que (0,025+w) ≤ x ≤ (0,3+w), et (0,025+w) ≤ z ≤ (0,3+w), et (0,1+w) ≤ y ≤ (0,5+w).

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente une diode électroluminescente à multiples puits quantiques de l'art antérieur,
- la figure 2 représente la structure de bandes au sein des différentes couches de la diode électroluminescente représentée sur la figure 1,
- la figure 3 représente la caractéristique I(V) de la diode électroluminescente représentée sur la figure 1,
- la figure 4 représente le taux de recombinaisons radiatives au sein des différentes couches de la diode électroluminescente représentée sur la figure 1,
- la figure 5 représente les concentrations en électrons et en trous au sein des différentes couches de la diode électroluminescente représentée sur la figure 1,
- la figure 6 représente le rendement quantique interne de la diode électroluminescente représentée sur la figure 1 en fonction de la densité de courant à l'anode de la diode électroluminescente,
- la figure 7 représente schématiquement une diode électroluminescente, objet de la présente invention, selon un mode de réalisation particulier,
- la figure 8 représente la structure de bandes au sein des différentes couches de la diode électroluminescente, objet de la présente invention, représentée sur la figure 7,
- la figure 9 représente la caractéristique I(V) de la diode électroluminescente, objet de la présente invention, représentée sur la figure 7,
- la figure 10 représente le taux de recombinaisons radiatives au sein des différentes couches de la diode électroluminescente, objet de la présente invention, représentée sur la figure 7,
- la figure 11 représente les concentrations en électrons et en trous au sein des différentes couches de la diode électroluminescente, objet de la présente invention, représentée sur la figure 7,
- la figure 12 représente le rendement quantique interne de la diode électroluminescente, objet de la présente invention, représentée sur la figure 7, en fonction de la densité de courant à l'anode de la diode électroluminescente,
- les figures 13 à 15 représentent des exemples de profils de variation de la composition en indium dans les semi-conducteurs des différentes couches de la diode, objet de la présente invention,
- les figures 16A et 16B représentent schématiquement des diodes électroluminescentes, objets de la présente invention, réalisées sous la forme de nanofils.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

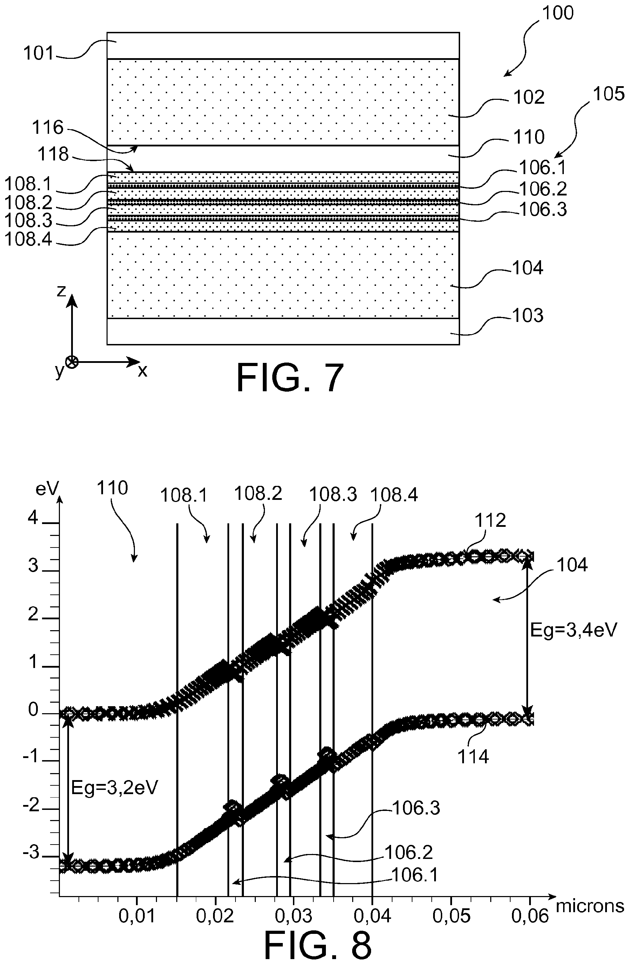

On se réfère tout d'abord à la figure 7 qui représente une diode électroluminescente 100 à multiples puits quantiques selon un mode de réalisation particulier.

La diode 100 comporte une jonction p-n formée par une première couche 102 comprenant du GaN dopé n (GaN-n) avec une concentration de donneurs égale à environ 10¹⁹ donneurs/cm³ et une deuxième couche 104 comprenant du GaN dopé p (GaN-p) avec une concentration d'accepteur égale à environ 2.10¹⁹ accepteurs/cm³. Ces deux couches 102 et 104 ont par exemple chacune une épaisseur (dimension selon l'axe Z représenté sur la figure 7) comprise entre environ 20 nm et 10 µm. Une première électrode métallique 101 est disposée contre la première couche 102 et forme une cathode de la diode 100, et une deuxième électrode métallique 103 est disposée contre la deuxième couche 104 et forme une anode de la diode 100. De manière générale, la première couche 102 peut avoir une concentration de donneurs comprise entre environ 10¹⁷ et 10²⁰ donneurs/cm³, et la deuxième couche 104 peut avoir une concentration d'accepteurs comprise entre environ 10¹⁵ et 10²⁰ accepteurs/cm³.

La diode 100 comporte, entre les couches 102 et 104, une zone active 105 comprenant plusieurs couches émissives 106. La diode 100 décrite ici comporte trois couches émissives 106, référencées 106.1, 106.2 et 106.3, formant chacune un puits quantique. De manière générale, la diode 100 peut comporter n couches émissives 106, avec n nombre entier tel que 2 ≤ n ≤ 20. Les couches émissives 106 comportent ici de l'In_{0,16}Ga_{0,84}N (c'est-à-dire comprenant 16 % d'indium pour 84 % de gallium) non intentionnellement dopé (de concentration en donneurs résiduels n_{nid} = 10¹⁷ cm⁻³) d'épaisseur égale à environ 1 nm. La zone active 105 de la diode 100 comporte également des couches barrières 108 (au nombre de quatre dans la diode 100 représentée sur la figure 7, et référencées 108.1, 108.2, 108.3 et 108.4) comprenant de l'In_{0,05}Ga_{0,95}N (comprenant 5 % d'indium pour 95 % de gallium) non intentionnellement dopé (de concentration en donneurs résiduels n_{nid} = 10¹⁷ cm⁻³) d'épaisseur égale à environ 5 nm. Deux des quatre couches barrières 108 sont interposées chacune entre deux couches émissives 106 consécutives, et les deux autres couches barrières 108 sont chacune interposée entre une des couches émissives 106 et l'une des couches 102 et 104. Ainsi, une première couche barrière 108.1 est disposée entre la première couche 102 de GaN-n et la première couche émissive 106.1. Une deuxième couche barrière 108.2 est disposée entre la première couche émissive 106.1 et la deuxième couche émissive 106.2. Une troisième couche barrière 108.3 est disposée entre la deuxième couche émissive 106.2 et la troisième couche émissive 106.3. Une quatrième couche barrière 108.4 est disposée entre la troisième couche émissive 106.3 et la deuxième couche 104 de GaN-p. De manière générale, la diode 100 qui comporte n couches émissives 106 comporte donc m couches barrières 108, avec m nombre entier égal à n+1. La zone active 105 est formée de l'empilement alterné des n couches émissives 106 et des n+1 couches barrières 108. Les couches 106 et 108 peuvent avoir des concentrations en donneurs résiduels comprises entre environ 10¹⁷ et 10²⁰ donneurs/cm³.

La diode 100 comporte également une couche tampon 110 disposée entre la zone active 105 et la première couche 102 de GaN-n, et notamment entre la première couche barrière 108.1 et la première couche 102 de GaN-n. Cette couche tampon 110 comporte de l'In_{0,05}Ga_{0,95}N, correspondant par exemple au même semi-conducteur que celui des couches barrières 108. Par contre, contrairement aux couches barrières 108, le semi-conducteur de la couche tampon 110 est dopé n avec une concentration en donneurs égale à environ 10¹⁹ donneurs/cm³, c'est-à-dire ici avec une concentration de dopants similaire à celle du GaN-n de la première couche 102. L'épaisseur de la couche tampon 110 (dimension selon l'axe Z représenté sur la figure 7) est par exemple comprise entre environ 5 nm et 10 µm. De manière générale, la couche tampon 110 peut avoir une concentration de donneurs compris entre 10¹⁷ et 10²⁰ donneurs/cm³ typiquement 10¹⁹ donneurs/cm³.

Les différentes simulations décrites ci-dessous sont réalisées avec le logiciel de simulation SILVACO® d'ATLAS®.

La structure de bandes à 0 V de la diode 100 polarisée, au sein des différentes couches de la diode 100 (sauf pour la première couche 102), est représentée sur la figure 8. Sur cette figure, la bande de conduction, en eV, comporte la référence 112 et la bande de valence, en également eV, comporte la référence 114. La partie gauche de ces bandes, correspondant aux bandes de conduction et de valence dans la couche tampon 110, montre un gap Eg égal à environ 3,2 eV dans la couche tampon 110. La partie droite de ces bandes, correspondant aux bandes dans la deuxième couche 104 de GaN-p, montre un gap Eg égal à environ 3,4 eV dans la deuxième couche 104. Cette différence de gap (Eg₁₁₀ est égal à environ 0.94.Eg₁₀₄) est obtenue principalement en raison de la présence de la couche tampon 110 entre la première couche 102 de GaN-n et la zone active 105, ainsi qu'en raison de l'indium présent dans le semi-conducteur des couches barrières 108. En effet, la présence de la couche tampon 110 entre la zone active 105 et la première couche 102 de GaN-n créé une asymétrie dans la jonction p-n de la diode 100. De ce fait, la barrière à franchir pour les trous pour circuler jusqu'à la couche tampon 110 n'est plus que de 3.2 eV alors qu'elle reste de 3.4 eV pour les électrons. Cela permet de répartir de manière homogène les trous dans tous les puits quantiques de la diode 100. De plus, le gap de la couche tampon 110 est de préférence supérieur d'au moins 2 % par rapport au gap des couches émissives 106, ou puits quantiques, améliorant ainsi le confinement dans les puits (Eg₁₁₀ ≥ 1,02 Eg_{106.1}; Eg₁₁₀ ≥ 1,02 Eg_{106.2}; Eg₁₁₀ ≥ 1,02 Eg_{106.3} dans l'exemple décrit ici).

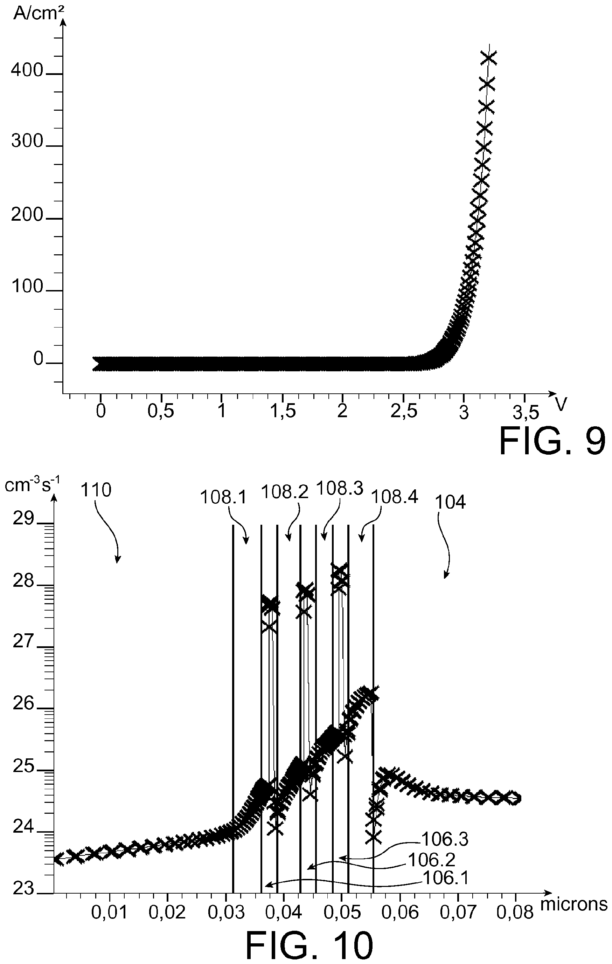

La caractéristique I(V) de la diode 100, c'est-à-dire la valeur de la densité de courant à l'anode de la diode 100 en fonction de la tension à l'anode de la diode 100, est représentée sur la figure 9. On voit sur la figure 9 qu'une tension de polarisation d'environ 3,2 V appliquée entre l'anode et la cathode de la diode 100 permet d'obtenir une densité de courant d'environ 450 A/cm², ce qui est bien supérieur à la densité de courant de 250 A/cm² obtenue avec la diode 10 de l'art antérieur. Cette forte densité de courant est due au fait que la répartition homogène des trous dans l'ensemble des puits quantiques de la diode 100 augmente fortement le taux de recombinaisons radiatives au sein des puits quantiques de la diode 100.

La figure 10 représente le taux de recombinaisons radiatives, en échelle logarithmique et par cm³.s, obtenues dans les différentes couches (sauf la première couche 102) de la diode 100 avec cette tension de polarisation de 3,2 V appliquée entre l'anode et la cathode de la diode 100. On voit sur cette figure qu'un taux de recombinaisons radiatives d'environ 10²⁸ cm⁻³s⁻¹ est obtenu dans les trois puits quantiques formés par les trois couches émissives 106.1, 106.2 et 106.3 de la diode 100. L'émission lumineuse obtenue dans la diode 100 est donc répartie de façon homogène dans les trois puits quantiques de la diode 100.

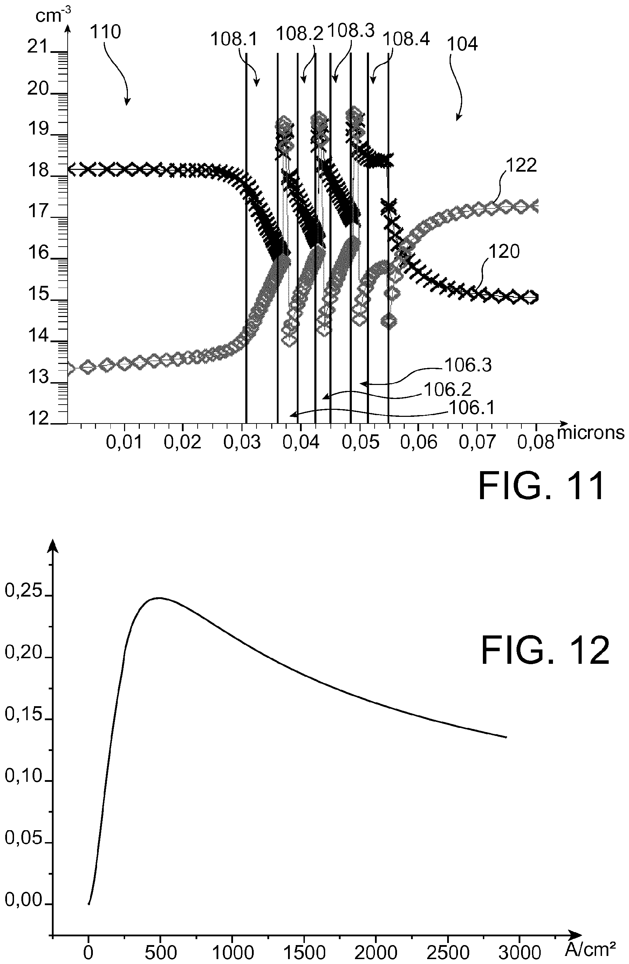

La figure 11 représente les concentrations en électrons (représentées par des croix référencées 120) et en trous (représentées par des losanges référencés 122), par cm³, obtenues dans les différentes couches de la diode 100 polarisée comme précédemment avec une tension de 3,2 V. On voit sur cette figure que les concentrations en électrons et en trous sont équivalentes dans tous les puits quantiques de la diode 100 (concentrations égales à environ 10¹⁹ cm⁻³), en raison de l'abaissement de la barrière énergétique à franchir pour les trous, facilitant ainsi leur diffusion dans tous les puits quantiques de la diode 100.

Le rendement quantique interne de la diode 100, qui correspond au rapport entre le nombre d'électrons injectés et le nombre de photons émis par les puits quantiques de la diode 100, en fonction de la densité de courant (en A/cm²) dans la diode 100 est représenté sur la figure 12. On voit sur cette figure que le rendement quantique interne maximum de la diode 100 est d'environ 25 % et est obtenu pour une densité de courant d'environ 500 A/cm², ce qui est bien supérieur au rendement maximum de 4 % obtenu avec la diode 10 de l'art antérieur (rendement multiplié par un facteur d'environ 6).

Pour obtenir des différences de taux de recombinaisons radiatives inférieures à environ 1 ordre de grandeur, c'est-à-dire que le taux de recombinaisons radiatives le plus faible dans les puits quantiques de la diode 100 ne soit pas inférieure à environ un dixième du taux de recombinaisons radiatives le plus élevé dans les puits quantiques de la diode 100, la diode 100 est réalisée en respectant de préférence les paramètres indiqués ci-dessous.

Lorsque la diode 100 comporte un nombre n de puits quantiques, et donc n couches émissives 106, tel que 2 ≤ n ≤ 5, et lorsque la composition en indium dans le semi-conducteur des couches barrières 108 est sensiblement égale ou inférieure à la composition en indium dans le semi-conducteur de la couche tampon 110, alors :
- Le semi-conducteur des couches émissives 106 comporte de préférence entre environ 10 % et 30 % d'indium ;
- Le semi-conducteur des couches barrières 108 comporte une composition x en indium de préférence supérieure à environ 2,5 % ;
- Le semi-conducteur des couches barrières 108 comporte une composition x en indium de préférence inférieure d'au moins environ 3 % par rapport à la composition y en indium du semi-conducteur des couches émissives 106 ;
- L'épaisseur de la couche tampon 110 est de préférence supérieure à environ 5 nm.

Ainsi, lorsque 2 ≤ n ≤ 5, pour une composition y en indium égale à environ 10 % dans les couches émissives 106, une composition x en indium égale à environ 2,5 % dans les couches barrières 108 (et donc également dans la couche tampon 110) est suffisante pour homogénéiser l'émission lumineuse dans l'ensemble des puits quantiques de la diode 100. Pour une composition y en indium égale à environ 22 %, une composition x en indium au moins égale à environ 8 % permet d'obtenir une bonne homogénéisation de l'émission lumineuse dans tous les puits quantiques de la diode 100. De plus, pour une diode 100 comprenant une zone active 105 comportant cinq puits quantiques, c'est-à-dire cinq couches émissives 106, avec une composition y en indium égale à environ 16 % dans les couches émissives 106, les couches barrières 108 et la couche tampon 110 peuvent être réalisées à partir d'un semi-conducteur présentant une composition x en indium égale à environ 8 %, la couche tampon 110 pouvant dans ce cas avoir une épaisseur supérieure à environ 20 nm.

Lorsque la diode 100 comporte un nombre n de puits quantiques tel que 5 ≤ n ≤ 10, et lorsque la composition en indium dans le semi-conducteur des couches barrières 108 est égale ou inférieure à la composition en indium dans le semi-conducteur de la couche tampon 110, alors :
- Le semi-conducteur des couches émissives 106 comporte de préférence entre environ 10 % et 30 % d'indium ;
- Le semi-conducteur des couches barrières 108 comporte de préférence une composition x en indium supérieure à environ 4 % ;
- Le semi-conducteur des couches barrières 108 comporte de préférence une composition x en indium inférieure d'au moins environ 3 % par rapport à la composition y en indium du semi-conducteur des couches émissives 106 ;
- L'épaisseur de la couche tampon 110 est de préférence supérieure à environ 5 nm.

Ainsi, lorsque 5 ≤ n ≤ 10, pour une composition y en indium égale à environ 10 % dans les couches émissives 106, une composition x en indium égale à environ 4 % dans les couches barrières 108 (et donc également dans la couche tampon 110) est suffisante pour homogénéiser l'émission lumineuse dans l'ensemble des puits quantiques de la diode 100. Pour une composition y en indium égale à environ 22 %, une composition x en indium au moins égale à environ 12 % permet d'obtenir une bonne homogénéisation de l'émission lumineuse dans tous les puits quantiques de la diode 100. De plus, pour une diode comprenant une zone active 105 formée de dix puits quantiques avec une composition y en indium égale à environ 16 % dans les couches émissives 106, les couches barrières 108 et la couche tampon 110 peuvent être réalisées à partir d'un semi-conducteur présentant une composition x en indium égale à environ 10 % ou 12 %, la couche tampon 110 pouvant dans ce cas avoir une épaisseur supérieure à environ 20 nm.

Lorsque la diode 100 comporte un nombre n de puits quantiques tel que n ≥ 10, et lorsque la composition en indium dans le semi-conducteur des couches barrières 108 est égale ou inférieure à la composition en indium dans le semi-conducteur de la couche tampon 110, alors :
- Le semi-conducteur des couches émissives 106 comporte de préférence entre environ 10 % et 30 % d'indium ;
- Le semi-conducteur des couches barrières 108 comporte de préférence une composition x en indium supérieure à environ 6 % ;
- Le semi-conducteur des couches barrières 108 comporte de préférence une composition x en indium inférieure d'au moins environ 3 % par rapport à la composition y en indium du semi-conducteur des couches émissives 106 ;
- L'épaisseur de la couche tampon 110 est de préférence supérieure à environ 5 nm.

Ainsi, lorsque n ≥ 10, pour une composition y en indium égale à environ 10 % dans les couches émissives 106, une composition x en indium égale à environ 6 % dans les couches barrières 108 (et donc également dans la couche tampon 110) est suffisante pour homogénéiser l'émission lumineuse dans l'ensemble des puits quantiques de la diode 100. Pour une composition y en indium égale à environ 22 %, une composition x en indium au moins égale à environ 13 % permet d'obtenir une bonne homogénéisation de l'émission lumineuse dans tous les puits quantiques de la diode 100. De plus, la couche tampon 110 peut dans ce cas avoir une épaisseur supérieure à environ 20 nm.

L'exemple de réalisation de la diode 100 précédemment décrit comporte une couche tampon 110 à base d'un semi-conducteur (de l'InGaN dans l'exemple décrit) présentant une composition en indium sensiblement égale à celle du semi-conducteur des couches barrières 108. En variante, il est possible que la composition en indium du semi-conducteur de la couche tampon 110 soit différente de celle du semi-conducteur des couches barrières 108, et notamment supérieure à celle du semi-conducteur des couches barrières 108.

De plus, la diode 100 précédemment décrite comporte une couche tampon 110 à base d'un semi-conducteur présentant une composition en indium constante dans l'ensemble de la couche tampon 110. En variante, la composition en indium, appelée z, du semi-conducteur de la couche tampon 110 peut varier entre une première valeur z₁ et une deuxième valeur z₂ supérieure à la première valeur z₁ selon une direction sensiblement perpendiculaire à une première face 116 de la couche tampon 110 contre laquelle la première couche 102 de GaN-n est disposée (c'est-à-dire le long de l'épaisseur de la couche tampon 110, parallèlement à l'axe Z représenté sur la figure 7), et dans laquelle la composition en indium z au niveau de la première face 116 de la couche tampon 110 est égale à la première valeur z₁. Il est dans ce cas avantageux d'avoir une couche tampon 110 dont le semi-conducteur comporte une composition en indium variable permettant de passer graduellement de la valeur de la composition en indium du semi-conducteur de la première couche 102 (valeur nulle dans les exemples précédemment décrits) à la valeur de la composition en indium du semi-conducteur de la première couche barrière 108.1 en contact avec la couche tampon 100 au niveau d'une face 118 opposée à la première face 116.

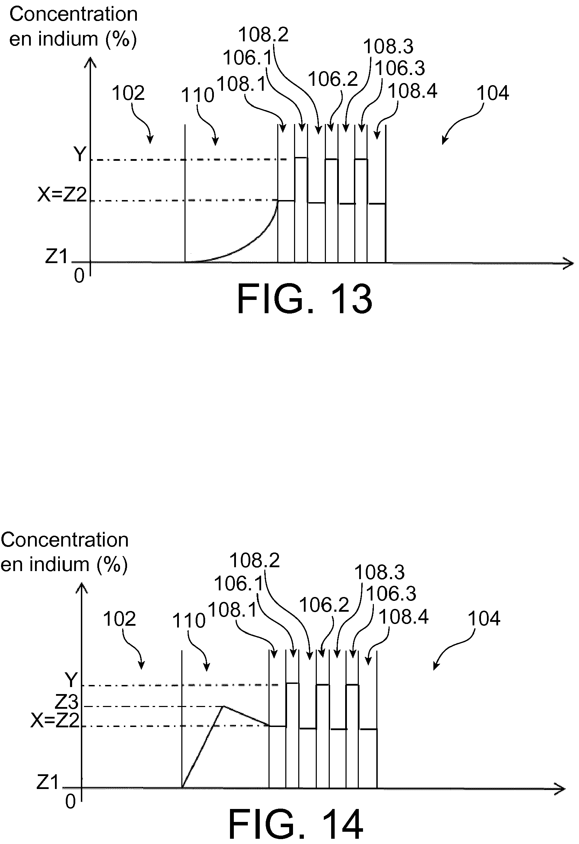

La figure 13 représente un premier exemple de profil de variation de la composition en indium dans les semi-conducteurs des différentes couches de la diode 100. Dans la première couche 102 de GaN-n, la composition en indium est sensiblement nulle. Dans la couche tampon 110, la composition en indium varie de manière croissante (par exemple de manière exponentielle) entre une première valeur z₁ sensiblement nulle et une deuxième valeur z₂ = x ou z₂ ≥ x, x correspondant à la composition en indium dans le semi-conducteur des couches barrières 108. La composition en indium dans le semi-conducteur des couches émissives 106 est appelée y et est supérieure à la valeur de x. Enfin, dans la deuxième couche 104 de GaN-p, la composition en indium est sensiblement nulle. Une telle variation de la composition en indium dans la couche tampon 110 peut être envisagée en réalisant la couche tampon 110 et la première couche barrière 108.1 telles que la somme des épaisseurs de ces deux couches soit supérieure ou égale à environ 5 nm. Ce profil de variation de la composition en indium dans la couche tampon 110 a pour avantage d'adapter de manière progressive le paramètre de maille du semi-conducteur de la première couche 102 à celui du semi-conducteur de la première couche barrière 108.1.

La figure 14 représente un deuxième exemple de profil de variation de la composition en indium dans les semi-conducteurs des différentes couches de la diode 100. Par rapport au premier exemple précédemment décrit en liaison avec la figure 13, la composition en indium du semi-conducteur de la couche tampon 110 croît tout d'abord de manière linéaire depuis la première valeur z₁ sensiblement nulle jusqu'à une troisième valeur z₃ supérieure à la valeur x, puis décroît de manière linéaire depuis la troisième valeur z₃ jusqu'à la deuxième valeur z₂ = x ou ou z₂ ≥ x. Ce profil de variation de la composition en indium dans la couche tampon 110 a pour avantage de favoriser encore plus le passage des trous dans les différents puits quantiques de la diode 100.

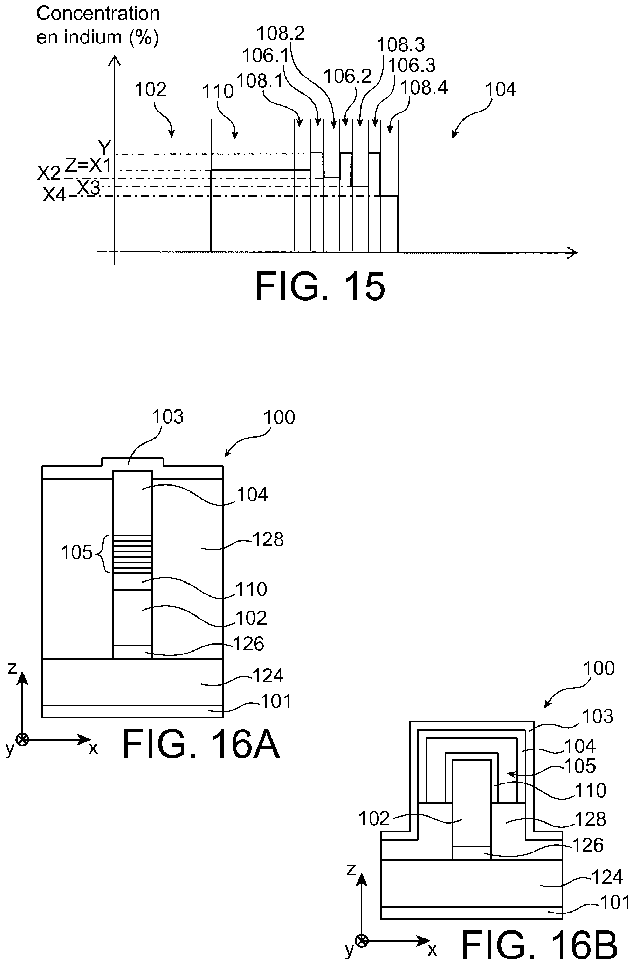

Dans une autre variante, il est également possible que chacune des couches barrières 108 soit à base d'un semi-conducteur présentant une composition en indium différente de celle des semi-conducteurs des autres couches barrières 108. La figure 15 représente un exemple de profil de variation de la composition en indium dans les semi-conducteurs des différentes couches d'une telle diode. On voit sur cette figure que la composition x₁ en indium du semi-conducteur de la première couche barrière 108.1 est égale à celle dans le semi-conducteur de la couche tampon 110. En variante, il est possible que la composition en indium du semi-conducteur de la couche tampon 110 soit variable, par exemple comme précédemment décrit en liaison avec les figures 13 et 14. La composition x₂ en indium dans la deuxième couche barrière 108.2 est inférieure à x₁. De même, la composition x₃ en indium dans la troisième couche barrière 108.3 est inférieure à x₂, et la composition x₄ en indium dans la quatrième couche barrière 108.4 est inférieure à x₃. Il est bien entendu possible que la diode 100 comporte un nombre de couches barrières différent dépendant du nombre de puits quantiques que comporte la diode 100. Une telle variante est avantageusement utilisée pour une diode comportant au moins trois puits quantiques et réalisée de préférence en respectant les paramètres ci-dessous.

Lorsque la diode 100 comporte un nombre n de puits quantiques, et donc de couches émissives 106, tel que 3 ≤ n ≤ 5, alors :
- Le semi-conducteur des couches émissives 106 comporte de préférence entre environ 10 % et 30 % d'indium ;
- Le semi-conducteur de la première couche barrière 108 (celle se trouvant en contact avec la couche tampon 110) comporte une composition x₁ en indium de préférence supérieure à environ 4 %, et le semi-conducteur de la dernière couche barrière 108 (celle se trouvant en contact avec la deuxième couche 104 de GaN-p) comporte une composition xₘ (m correspondant au nombre total de couches barrières de la diode) en indium de préférence égale à environ 0,5 % ;
- L'épaisseur de la couche tampon 110 est de préférence supérieure à environ 5 nm.

Ainsi, pour une diode 100 comprenant une zone active 105 formée de cinq puits quantiques, ou cinq couches émissives 106, avec une composition y en indium égale à environ 16 % dans les couches émissives 106, la première couche barrière 108.1 peut être réalisée à partir d'un semi-conducteur présentant une composition x₁ en indium égale à environ 6,5 % ou 7,5%. La composition en indium des autres couches barrières peut diminuer de 1 % pour chacune des couches barrières suivantes jusqu'à arriver à la dernière couche barrière 108.6 (celle en contact avec la deuxième couche 104 de GaN-p) dont la composition x₆ en indium est alors égale à environ 0,5 % ou environ 1,5 %.

Lorsque la diode 100 comporte un nombre n de puits quantiques tel que 5 ≤ n ≤ 10, alors :
- Le semi-conducteur des couches émissives 106 comporte de préférence entre environ 10 % et 30 % d'indium ;
- Le semi-conducteur de la première couche barrière 108 comporte une composition x₁ en indium de préférence supérieure à environ 8 %, et le semi-conducteur de la dernière couche barrière 108 comporte une composition xₘ en indium de préférence égale à environ 0,5 % ;
- L'épaisseur de la couche tampon 110 est de préférence supérieure à environ 5 nm.

Lorsque la diode 100 comporte un nombre n de puits quantiques tel que n ≥ 10, alors :
- Le semi-conducteur des couches émissives 106 comporte de préférence entre environ 10 % et 30 % d'indium ;
- Le semi-conducteur de la première couche barrière 108 comporte une composition x₁ en indium de préférence supérieure à environ 12 %, et le semi-conducteur de la dernière couche barrière 108 comporte une composition xₘ en indium de préférence égale à environ 2,5 % ;
- L'épaisseur de la couche tampon 110 est de préférence supérieure à environ 5 nm.

Ainsi, pour une diode comprenant une zone active 105 formée de dix puits quantiques, ou dix couches émissives 106, avec un composition y en indium égale à environ 16 % dans les couches émissives 106, la première couche barrière 108.1 peut être réalisée à partir d'un semi-conducteur présentant une composition x₁ en indium égale à environ 14 %. La composition en indium des autres couches barrières peut diminuer de 1 % pour chacune des couches barrières suivantes jusqu'à arriver à la dernière couche barrière 108.11 dont la composition x₁₁ en indium est égale à environ 3 %.

Dans une variante de réalisation, il est possible que le semi-conducteur dopé p de la deuxième couche 104 soit en partie composé d'indium, et correspond par exemple à de l'InGaN dopé p. Dans ce cas, les valeurs des compositions en indium des autres éléments de la diode 100 (couche tampon 110, couches barrières 108, couches émissives 106) pourront se baser sur les exemples de valeurs précédemment décrites, mais majorées du pourcentage d'indium se trouvant dans le semi-conducteur de la deuxième couche 104. De plus, selon cette variante, la composition en indium du semi-conducteur de la couche tampon 110 sera de préférence similaire à la composition en indium du semi-conducteur de la première couche barrière 108 se trouvant en contact avec la couche tampon 110, ou bien être variable et notamment supérieure comme précédemment décrit en liaison avec les figures 13 et 14.

Enfin, il est également possible que dans la diode 100, la première couche 102 de semi-conducteur dopé n et la couche tampon 110 correspondent à une seule et même couche d'un même semi-conducteur dopé n, par exemple de l'InGaN-n. Dans ce cas, la concentration de dopage en donneurs d'une telle couche peut être similaire à celle précédemment décrite pour la première couche 102 de GaN-n, et la composition en indium d'une telle couche peut être similaire à celle précédemment décrite pour la couche tampon 110.

L'épaisseur d'une telle couche peut être comprise entre environ 20 nm et 10 µm.

Cette unique couche de semi-conducteur dopé n peut être en contact avec un substrat de silicium, de saphir, de SiC ou encore de GaN intrinsèque, ou avec une couche dopée n de silicium, de SiC, etc.

Dans une autre variante, il est possible que la jonction p-n de la diode 100 soit formée par une première couche 102 d'InGaN-n et par une deuxième couche 104 d'InGaN-p. Les matériaux de la couche tampon 110 et de la deuxième couche 104 sont tels que le semi-conducteur dopé n de la couche tampon 110 présente une énergie de bande interdite inférieure ou égale à environ 97 % de l'énergie de bande interdite du semi-conducteur dopé p de la deuxième couche 104 (Eg₁₁₀ ≤ 0,97 Eg₁₀₄), ce qui se traduit par une concentration en indium dans le semi-conducteur dopé n de la couche tampon 110 supérieure d'au moins 2,5 % par rapport à la concentration en indium dans le semi-conducteur dopé p de la deuxième couche 104. Dans ce cas, dans les différentes inégalités indiquées précédemment, les valeurs des concentrations en indium x et y des semi-conducteurs des couches barrières 108 et des couches émissives 106 sont majorées de la valeur de la concentration en indium dans le semi-conducteur dopé p de la deuxième couche 104.

Dans les différents exemples et variantes précédemment décrits, le semi-conducteur utilisé pour les différents éléments de la diode 100 est du GaN (avec ajout d'indium pour la réalisation des couches émissives, des couches barrières et de la couche tampon, et éventuellement aussi pour la réalisation de la première couche 102 et/ou de la deuxième couche 104).

Toutefois, il est possible de réaliser la diode 100 à partir de n'importe quel semi-conducteur permettant de réaliser des jonctions p-n adaptées pour des diodes électroluminescentes à multiples puits quantiques et présentant de grandes différences de mobilité pour les électrons et les trous et/ou de grandes différences de dopage. Il est notamment possible d'utiliser, à la place du GaN, des semi-conducteurs à grands gaps tels que par exemple du GalnN, du ZnO, du ZnMgO, ou du ZnMgO pouvant potentiellement servir à réaliser une émission lumineuse dans la gamme des longueurs d'ondes correspondant à la couleur bleu ou à l'ultra-violet. Il est également possible d'utiliser des semi-conducteurs à plus petits gaps tels que par exemple de l'InP, du GaP, de l'InGaP, de l'InAs, du GaAs, de l'InGaAs, de l'AlGaInP, de l'AIGaAs.

En variante, la diode 100 peut également comporter une couche de blocage d'électrons, par exemple à base d'AIGaN, disposée entre la dernière couche barrière (correspondant à la couche 108.4 dans les exemples précédemment décrits) et la deuxième couche 104 de semi-conducteur dopé p.

Une telle couche de blocage d'électrons permet d'empêcher encore plus le passage des électrons vers la deuxième couche 104 de semi-conducteur dopé p.

Une telle couche de blocage d'électrons permet de diminuer également le DROOP, c'est-à-dire la chute de l'efficacité quantique interne lorsque la densité de courant dans la diode augmente, cette chute étant partiellement due à l'échappement des électrons de la zone active quand on augmente le courant. En se référant à la figure 12, l'ajout d'une telle couche de blocage d'électrons permet d'atténuer la baisse du rendement quantique interne de la diode lorsque la densité de courant est supérieure à environ 500 A/cm².

La diode électroluminescente 100 selon l'invention précédemment décrite, comportant une zone active formée d'une alternance de puits quantiques et de couches barrières, et une couche tampon, peut être réalisée sous la forme d'une diode planaire, c'est-à-dire sous la forme d'un empilement de couches (102, 110, 105 et 104) formées sur un substrat, comme représenté sur la figure 7, les faces principales des différentes couches étant disposées parallèlement au plan du substrat (parallèle au plan (X,Y)).

En variante, la diode électroluminescente 100 selon l'invention peut également être réalisée sous la forme d'un nanofil. La figure 16A représente une telle diode 100 réalisée sous la forme d'un nanofil axial, ce nanofil comportant une empilement formé de la première électrode 101, d'un substrat 124 de semi-conducteur (par exemple du silicium) de type n, d'une couche de nucléation 126 permettant la croissance du nanofil, de la première couche 102 de semi-conducteur dopé n, de la couche tampon 110 de semi-conducteur dopé n, de la zone active 105, de la deuxième couche 104 de semi-conducteur dopé p, et de la deuxième électrode 103. Un matériau isolant 128 peut entourer au moins une partie de ce nanofil qui s'étend parallèlement à l'axe Z.

La figure 16B représente une diode 100 réalisée sous la forme d'un nanofil radial, ce nanofil comportant un empilement formé de la première électrode 101, du substrat 124 de semi-conducteur, de la couche de nucléation 126 et de la première couche 102 de semi-conducteur dopé n. Des portions isolantes 128 entourent en partie la première couche 102 et la couche de nucléation 126. La couche tampon 110 est réalisée telle qu'elle entoure au moins une partie de la première couche 102. La zone active 105 (formée des couches barrières 108 et des couches émissives 106) est réalisée telle qu'elle entoure la couche tampon 110. La deuxième couche 104 de semi-conducteur dopé p est réalisée telle qu'elle entoure la zone active 105. Enfin, la deuxième électrode 103 est réalisée en recouvrant la deuxième couche 104.

En variante des deux exemples de réalisation décrits sur les figures 16A et 16B, la structure de ces nanofils peut être inversée, avec dans ce cas un substrat 124 de semi-conducteur de type p sur lequel est réalisée la deuxième couche 104, puis les autres éléments de la diode 100 dans l'ordre inverse de celui décrit sur les figures 16A et 16B.

Les différentes caractéristiques (épaisseurs, dopage, etc.) précédemment exposées pour la diode 100 de type planaire peuvent être similaires pour la diode 100 réalisée sous la forme d'un nanofil.

## Revendications

1. Diode électroluminescente (100) comportant :
- une première couche (102) de semi-conducteur dopé n apte à former une cathode de la diode (100), et une deuxième couche (104) de semi-conducteur dopé p apte à former une anode de la diode (100), la première (102) et la deuxième couche (104) formant une jonction p-n de la diode (100) ;
- une zone active (105) disposée entre la première couche (102) et la deuxième couche (104), comprenant au moins deux couches émissives (106) comportant du semi-conducteur et aptes à former des puits quantiques, et une pluralité de couches barrières (108) de semi-conducteur telles que chaque couche émissive (106) soit disposée entre deux couches barrières (108) qui sont en contact avec ladite couche émissive (106) au niveau de deux faces opposées de ladite couche émissive (106) ;
- une couche tampon (110) de semi-conducteur dopé n disposée entre la première couche (102) et la zone active (105), ledit semi-conducteur dopé n de la couche tampon (110) comportant une énergie de bande interdite inférieure ou égale à environ 97 % de l'énergie de bande interdite du semi-conducteur dopé p de la deuxième couche(104) ;
dans laquelle le semi-conducteur des couches barrières (108) est de l'In_{X}Ga_{1-X}N, le semi-conducteur de la couche tampon (110) est de l'In_{Z}Ga_{1-Z}N, et le semi-conducteur des couches émissives (106) est de l'In_{Y}Ga_{1-Y}N, avec x, y et z nombres réels **caractérisé en ce que** 0,025 ≤ x, et 0,025 ≤ z, et 0,1 ≤ y, et x < y, et z < y, ou
dans laquelle, lorsque la diode (100) comporte m couches barrières (108), le semi-conducteur de chacune des couches barrières (108) est de l'In_{Xi}Ga_{1-Xi}N, avec i nombre entier compris entre 1 et m, le semi-conducteur de la couche tampon (110) est de l'In_{Z}Ga_{1-Z}N, et le semi-conducteur des couches émissives (106) est de l'In_{Y}Ga_{1-Y}N, avec xᵢ, y et z nombres réels tels que 0,025 ≤ z, et 0,1 ≤ y, et xᵢ < y, et z < y, et dans laquelle la composition en indium xᵢ du semi-conducteur de chaque couche barrière (108) est différente de celles des autres couches barrières (108), ces compositions en indium variant graduellement de manière décroissante depuis une première valeur x₁, correspondant à la composition en indium du semi-conducteur d'une des couches barrières (108) disposée contre la couche tampon (110), telle que x₁ ≤ z, jusqu'à une autre valeur xₘ correspondant à la composition en indium du semi-conducteur d'une des couches barrières (108) disposée contre la deuxième couche (104), telles que xₘ < x₁, et avec m ≥ 3.

2. Diode électroluminescente (100) selon la revendication 1, dans laquelle le semi-conducteur dopé n de la première couche (102) et/ou le semi-conducteur dopé p de la deuxième couche (104) sont du GaN, et/ou les semi-conducteurs des couches émissives (106) et/ou des couches barrières (108) et/ou de la couche tampon (110) sont de l'InGaN.

3. Diode électroluminescente (100) selon l'une des revendications précédentes, dans laquelle une concentration en indium du semi-conducteur dopé n de la couche tampon (110) est supérieure d'au moins 2,5 % par rapport à une concentration en indium du semi-conducteur dopé p de la deuxième couche (104).

4. Diode électroluminescente (100) selon l'une des revendications précédentes, dans laquelle la couche tampon (110) et la première couche (102) comportent un semi-conducteur de composition et/ou de dopage identiques.

5. Diode électroluminescente (100) selon l'une des revendications précédentes, dans laquelle une épaisseur de la couche tampon (110) est supérieure à environ 5 nm.

6. Diode électroluminescente (100) selon l'une des revendications précédentes, dans laquelle, lorsque la diode (100) comporte un nombre n de couches émissives (106) tel que 2 ≤ n ≤ 5, les semi-conducteurs des couches barrières (108) et des couches émissives (106) sont tels que (x + 0,03) ≤ y ou tels que x₁ > 0,04 et xₘ ≥ 0,005, et (x₁ + 0,03) ≤ y.

7. Diode électroluminescente (100) selon l'une des revendications 1 à 5, dans laquelle, lorsque la diode (100) comporte un nombre n de couches émissives (106) tel que 5 ≤ n ≤ 10, les semi-conducteurs des couches barrières (108) et des couches émissives (106) sont tels que x ≥ 0,04 et (x + 0,03) ≤ y ou tels que x₁ > 0,08 et xₘ ≥ 0,005 et (x₁ + 0,03) ≤ y, et/ou l'épaisseur de la couche tampon (110) est supérieure à environ 20 nm.

8. Diode électroluminescente (100) selon l'une des revendications 1 à 5, dans laquelle, lorsque la diode (100) comporte un nombre n de couches émissives (106) tel que n ≥ 10, les semi-conducteurs des couches barrières (108) et des couches émissives (106) sont tels que x ≥ 0,06 et (x + 0,03) ≤ y ou tels que x₁ > 0,12 et xₘ ≥ 0,025 et (x₁ + 0,03) ≤ y, et/ou l'épaisseur de la couche tampon (110) est supérieure à environ 20 nm.

9. Diode électroluminescente (100) selon l'une des revendications précédentes, dans laquelle la composition en indium z du semi-conducteur de la couche tampon (110) est sensiblement égale ou supérieure à la composition en indium x du semi-conducteur des couches barrières (108).

10. Diode électroluminescente (100) selon l'une des revendications 1 à 8, dans laquelle la composition en indium z du semi-conducteur de la couche tampon (110) varie entre une première valeur z₁ et une deuxième valeur z₂ supérieure à la première valeur z₁ selon une direction sensiblement perpendiculaire à une première face (116) de la couche tampon (110) contre laquelle la première couche (102) est disposée, et dans laquelle la composition en indium z au niveau de la première face (116) de la couche tampon (110) est égale à la première valeur z₁, et dans laquelle, lorsque la composition en indium du semi-conducteur de chacune des couches barrières (108) est différente de celle des autres couches barrières (108), la composition en indium x₁ est telle que x₁ ≤ z₂.

11. Diode électroluminescente (100) selon la revendication 10, dans laquelle la composition en indium z du semi-conducteur de la couche tampon (110) varie de manière croissante entre z₁ et z₂, avec z₁ = 0, et z₂ ≥ x ou z₂ ≥ x₁.

12. Diode électroluminescente (100) selon la revendication 10, dans laquelle la composition en indium z du semi-conducteur de la couche tampon (110) varie de manière croissante entre z₁ et une troisième valeur z₃ > z₂, et varie de manière décroissante entre z₃ et z₂, avec z₁ = 0 et z₂ ≥ x ou z₂ ≥ x₁.

13. Diode électroluminescente (100) selon l'une des revendications précédentes, dans laquelle le semi-conducteur dopé p de la deuxième couche (104) est de l'In_{W}Ga_{1-W}N, avec w nombre réel tel que w < 0,12 et dans laquelle, lorsque le semi-conducteur des couches barrières (108) est de l'In_{X}Ga_{1-X}N, que le semi-conducteur de la couche tampon (110) est de l'In_{Z}Ga_{1-Z}N, et que le semi-conducteur des couches émissives (106) est de l'In_{Y}Ga_{1-Y}N, les compositions en indium w, x, y et z sont telles que (0,025+w) ≤ x, et (0,025+w) ≤ z, et (0,1+w) ≤ y.

## Patentansprüche

1. Leuchtdiode (100), umfassend:
- eine erste Schicht (102) aus einem n-dotierten Halbleiter, die dazu ausgelegt ist, eine Kathode der Diode (100) zu bilden, und eine zweite Schicht (104) aus einem p-dotierten Halbleiter, die dazu ausgelegt ist, eine Anode der Diode (100) zu bilden, wobei die erste (102) und die zweite Schicht (104) einen p-n-Übergang der Diode (100) bilden;
- eine aktive Zone (105), die zwischen der ersten Schicht (102) und der zweiten Schicht (104) angeordnet ist, umfassend wenigstens zwei emittierende Schichten (106), die einen Halbleiter umfassen und dazu ausgelegt sind, Quantentöpfe zu bilden, sowie eine Mehrzahl von Barriereschichten (108) aus Halbleiter derart, dass jede emittierende Schicht (106) zwischen zwei Barriereschichten (108) angeordnet ist, die in Kontakt mit der emittierenden Schicht (106) im Bereich von zwei entgegengesetzten Flächen der emittierenden Schicht (106) sind;
- eine Pufferschicht (110) aus einem n-dotierten Halbleiter, die zwischen der ersten Schicht (102) und der aktiven Zone (105) angeordnet ist, wobei der n-dotierte Halbleiter der Pufferschicht (110) eine Energie des verbotenen Bands kleiner oder gleich ungefähr 97 % der Energie des verbotenen Bands des p-dotierten Halbleiters der zweiten Schicht (104) hat;
wobei der Halbleiter der Barriereschichten (108) InₓGa₁₋ₓN ist, der Halbleiter der Pufferschicht (110) In_{z}Ga_{1-z}N ist, und der Halbleiter der emittierenden Schichten (106) In_{y}Ga_{1-y}N ist, wobei x, y und z reelle Zahlen sind,
**dadurch gekennzeichnet, dass** 0,025 ≤ x, und 0,025 ≤ z, und 0,1 ≤ y, und x < y, und z < y, oder
wobei dann, wenn die Diode (100) m Barriereschichten (108) umfasst, der Halbleiter von jeder der Barriereschichten (108) InₓᵢGa₁₋ₓᵢN ist, wobei i eine ganze Zahl zwischen 1 und m ist, wobei der Halbleiter der Pufferschicht (110) In_{z}Ga_{1-z}N ist, und wobei der Halbleiter der emittierenden Schichten (106) In_{y}Ga_{1-y}N ist, wobei xᵢ, y und z reelle Zahlen derart sind, dass 0,025 ≤ z, und 0,1 ≤ y, und xᵢ < y, und z < y, und wobei die Indiumzusammensetzung xᵢ des Halbleiters von jeder Barriereschicht (108) verschieden ist von jenen der anderen Barriereschichten (108), wobei diese Indiumzusammensetzungen schrittweise in abnehmender Weise von einem ersten Wert x₁ aus variieren, der der Indiumzusammensetzung des Halbleiters von einer der Barriereschichten (108) entspricht, die gegen die Pufferschicht (110) angeordnet ist, derart, dass x₁ ≤ z, bis zu einem anderen Wert xₘ, der der Indiumzusammensetzung des Halbleiters von einer der Barriereschichten (108) entspricht, die gegen die zweite Schicht (104) angeordnet ist, derart, dass xₘ < x₁, und mit m ≥ 3.

2. Leuchtdiode (100) nach Anspruch 1, wobei der n-dotierte Halbleiter der ersten Schicht (102) und/oder der p-dotierte Halbleiter der zweiten Schicht (104) GaN ist/sind, und/oder die Halbleiter der emittierenden Schichten (106) und/oder der Barrieerschichten (108) und/oder der Pufferschicht (110) InGaN sind.

3. Leuchtdiode (100) nach einem der vorhergehenden Ansprüche, wobei eine Indiumkonzentration des n-dotierten Halbleiters der Pufferschicht (110) um wenigstens 2,5 % größer ist bezogen auf eine Indiumkonzentration des p-dotierten Halbleiters der zweiten Schicht (104).

4. Leuchtdiode (100) nach einem der vorhergehenden Ansprüche, wobei die Pufferschicht (110) und die erste Schicht (102) einen Halbleiter mit identischer Zusammensetzung und/oder Dotierung umfassen.

5. Leuchtdiode (100) nach einem der vorhergehenden Ansprüche, wobei eine Dicke der Pufferschicht (110) größer als ungefähr 5 nm ist.

6. Leuchtdiode (100) nach einem der vorhergehenden Ansprüche, wobei dann, wenn die Diode (100) eine Zahl n von emittierenden Schichten (106) derart hat, dass 2 ≤ n ≤ 5, die Halbleiter der Barriereschichten (108) und der emittierenden Schichten (106) derart sind, dass (x + 0,03) ≤ y, oder derart, dass x₁ > 0,04 und xₘ ≥ 0,005, und (x₁ + 0,03) ≤ y.

7. Leuchtdiode (100) nach einem der Ansprüche 1 bis 5, wobei dann, wenn die Diode (100) eine Zahl n von emittierenden Schichten (106) derart hat, dass 5 ≤ n ≤ 10, die Halbleiter der Barriereschichten (108) und der emittierenden Schichten (106) derart sind, dass x ≥ 0,04 und (x + 0,03) ≤ y, oder derart, dass x₁ > 0,08 und xₘ ≥ 0,005, und (x₁ + 0,03) ≤ y, und/oder die Dicke der Pufferschicht (110) größer als ungefähr 20 nm ist.

8. Leuchtdiode (100) nach einem der Ansprüche 1 bis 5, wobei dann, wenn die Diode (100) eine Zahl n von emittierenden Schichten (106) derart hat, dass n ≥ 10, die Halbleiter der Barriereschichten (108) und der emittierenden Schichten (106) derart sind, dass x ≥ 0,06 und (x + 0,03) ≤ y, oder derart, dass x₁ > 0,12 und x₁ > 0,12 und xₘ ≥ 0,025 und (x₁ + 0,03) ≤ y, und/oder die Dicke der Pufferschicht (110) größer als ungefähr 20 nm ist.

9. Leuchtdiode (100) nach einem der vorhergehenden Ansprüche, wobei die Indiumzusammensetzung z des Halbleiters der Pufferschicht (110) im Wesentlichen größer oder gleich der Indiumzusammensetzung x des Halbleiters der Barriereschichten (108) ist.

10. Leuchtdiode (100) nach einem der Ansprüche 1 bis 8, wobei die Indiumzusammensetzung z des Halbleiters der Pufferschicht (110) variiert zwischen einem ersten Wert z₁ und einem zweiten Wert z₂ größer als der erste Wert z₁ entlang einer Richtung im Wesentlichen orthogonal zu einer ersten Fläche (116) der Pufferschicht (110), gegen die die erste Schicht (102) angeordnet ist, und wobei die Indiumzusammensetzung z im Bereich der ersten Fläche (116) der Pufferschicht (110) gleich dem ersten Wert z₁ ist, und wobei dann, wenn die Indiumzusammensetzung des Halbleiters von jeder der Barriereschichten (108) verschieden ist von jener der anderen Barriereschichten (108), die Indiumzusammensetzung x₁ derart ist, dass x₁ ≤ z₂.

11. Leuchtdiode (100) nach Anspruch 10, wobei die Indiumzusammensetzung z des Halbleiters der Pufferschicht (110) auf zunehmende Weise zwischen z₁ und z₂ variiert, mit z₁ = 0, und z₂ ≥ x oder z₂ ≥ x₁.

12. Leuchtdiode (100) nach Anspruch 10, wobei die Indiumzusammensetzung z des Halbleiters der Pufferschicht (110) auf zunehmende Weise zwischen z₁ und einem dritten Wert z₃ > z₂ variiert, und auf abnehmende Weise zwischen z₃ und z₂ variiert, mit z₁ = 0, und z₂ ≥ x oder z₂ ≥ x₁.

13. Leuchtdiode (100) nach einem der vorhergehenden Ansprüche, wobei der p-dotierte Halbleiter der zweiten Schicht (104) In_{w}Ga_{1-w}N ist, wobei w eine reelle Zahl derart ist, dass w ≤ 0,12, und wobei dann, wenn der Halbleiter der Barriereschichten (108) InₓGa₁₋ₓN ist, der Halbleiter der Pufferschicht (110) In_{z}Ga_{1-z}N ist, und der Halbleiter der emittierenden Schichten (106) In_{y}Ga_{1-y}N ist, die Indiumzusammensetzungen w, x, y und z derart sind, dass (0,025 + w) ≤ x, und (0,025 + w) ≤ z, und (0,1 + w) ≤ y.

## Claims

1. Light-emitting diode (100) comprising:
- a first n-doped semiconductor layer (102) capable of forming a cathode of the diode (100), and a second p-doped semiconductor layer (104) capable of forming an anode of the diode (100), the first (102) and the second (104) layer forming a p-n junction of the diode (100);
- an active zone (105) located between the first layer (102) and the second layer (104), including at least two emissive layers (106) comprising the semiconductor and capable of forming quantum wells, and a plurality of semiconductor barrier layers (108) such that each emissive layer (106) is located between two barrier layers (108) that are in contact with said emissive layer (106) at two opposite faces of said emissive layer (106);
- an n-doped semiconductor buffer layer (110) located between the first layer (102) and the active zone (105), said n-doped semiconductor in the buffer layer (110) having a band gap energy less than or equal to about 97% of the band gap energy of the p-doped semiconductor of the second layer (104);
in which the semiconductor of the barrier layers (108) is InₓGa₁₋ₓN, the semiconductor of the buffer layer (110) is In_{Z}Ga_{1-Z}N, and the semiconductor of the emissive layers (106) is In_{Y}Ga_{1-Y}N, where x, y and z are real numbers, **characterized in that** 0.025 ≤ x, and 0.025 ≤ z, and 0.1 ≤ y, and x < y, and z < y, or
in which, when the diode (100) comprises m barrier layers (108), the semiconductor in each of the barrier layers (108) is In_{Xi}Ga_{1-Xi}N, where i is an integer number between 1 and m, the semiconductor of the buffer layer (110) is In_{Z}Ga_{1-Z}N, and the semiconductor of emissive layers (106) is In_{Y}Ga_{1-Y}N, where xᵢ, y and z are real numbers such that 0.025 ≤ z, and 0.1 ≤ y, and xᵢ < y, and z < y, and in which the indium composition xᵢ in the semiconductor of each barrier layer (108) is different from the indium compositions of the other barrier layers (108), these indium compositions gradually varying and decreasing from a first value x₁, corresponding to the indium composition in the semiconductor of one of the barrier layers (108) in contact with the buffer layer (110), such that x₁ ≤ z, up to another value xₘ corresponding to the indium composition in the semiconductor of one of the barrier layers (108) in contact with the second layer (104), such that xₘ < x₁, and where m ≥ 3.

2. Light-emitting diode (100) according to claim 1, in which the n-doped semiconductor of the first layer (102) and/or the p-doped semiconductor of the second layer (104) are GaN, and/or the semiconductors of the emissive layers (106) and/or the barrier layers (108) and/or the buffer layer (110) are InGaN.

3. Light-emitting diode (100) according to one of the previous claims, in which an indium concentration in the n-doped semiconductor of the buffer layer (110) is at least 2.5% more than the indium concentration in the p-doped semiconductor of the second layer (104).

4. Light-emitting diode (100) according to one of the previous claims, in which the buffer layer (110) and the first layer (102) comprise a semiconductor with an identical composition and/or doping.

5. Light-emitting diode (100) according to one of the previous claims, in which the buffer layer (110) is more than about 5 nm thick.

6. Light-emitting diode (100) according to one of the previous claims, in which, when the diode (100) contains a number n of emissive layers (106) such that 2 ≤ n ≤ 5, the semiconductors of the barrier layers (108) and emissive layers (106) are such that (x + 0.03) ≤ y or such that x₁ > 0.04 and xₘ ≥ 0.005, and (x₁ + 0.03) ≤ y.

7. Light-emitting diode (100) according to one of claims 1 to 5, in which, when the diode (100) comprises a number n of emissive layers (106) such that 5 ≤ n ≤ 10, the semiconductors of the barrier layers (108) and the emissive layers (106) are such that x ≥ 0.04 and (x + 0.03) ≤ y or such that x₁ > 0.08 and xₘ ≥ 0.005 and (x₁ + 0.03) ≤ y, and/or the thickness of the buffer layer (110) is more than about 20 nm.

8. Light-emitting diode (100) according to one of claims 1 to 5, in which, when the diode (100) comprises a number n of emissive layers (106) such that n ≥ 10 the semiconductors of the barrier layers (108) and the emissive layers (106) are such that x ≥ 0.06 and (x + 0.03) ≤ y or such that x₁ > 0.12 and xₘ ≥ 0.025 and (x₁ + 0.03) ≤ y, and/or the thickness of the buffer layer (110) is more than about 20 nm.

9. Light-emitting diode (100) according to one of the previous claims, in which the indium composition z in the semiconductor of the buffer layer (110) is approximately equal to or greater than the indium composition x in the semiconductor of the barrier layers (108).

10. Light-emitting diode (100) according to one of claims 1 to 8, in which the indium composition z in the semiconductor of the buffer layer (110) varies between a first value z₁ and a second value z₂ greater than the first value z₁ along a direction approximately perpendicular to a first face (116) of the buffer layer (110) in contact with which the first layer (102) is located, and in which the indium composition z at the first face (116) of the buffer layer (110) is equal to the first value z₁, and in which, when the indium composition in the semiconductor of each of the barrier layers (108) is different from the indium composition of the other barrier layers (108), the indium composition x₁ is such that x₁ ≤ z₂.

11. Light-emitting diode (100) according to claim 10, in which the indium composition z in the semiconductor of the buffer layer (110) varies by increasing between z₁ and z₂, where z₁ = 0 and z₂ ≥ x or z₂ ≥ x₁.

12. Light-emitting diode (100) according to claim 10, in which the indium composition z in the semiconductor of the buffer layer (110) varies by increasing between z₁ and a third value z₃ > z₂, and varies by decreasing between z₃ and z₂, where z₁ = 0 and z₂ ≥ x or z₂ ≥ x₁.

13. Light-emitting diode (100) according to one of the previous claims, in which the p-doped semiconductor of the second layer (104) is In_{W}Ga_{1-W}N, where w is a real number such that w < 0.12 and in which when the semiconductor of the barrier layers (108) is In_{X}Ga_{1-X}N, the semiconductor of the buffer layer (110) is In_{Z}Ga_{1-Z}N, and the semiconductor of the emissive layers (106) is In_{Y}Ga_{1-Y}N, the indium compositions w, x, y and z are such that (0.025+w) ≤ x, and (0.025+w) ≤ z, and (0.1+w) ≤ y.
